(19) Europäisches Patentamt
European Patent Office
Office européen des brevets

(11) Veröffentlichungsnummer: **0 247 461 B1**

(12) **EUROPÄISCHE PATENTSCHRIFT**

(45) Veröffentlichungstag der Patentschrift: **30.03.94**

(51) Int. Cl.[5]: **G03F 7/021**

(21) Anmeldenummer: **87107064.5**

(22) Anmeldetag: **15.05.87**

# (54) Lichtempfindliches Gemisch und daraus hergestelltes lichtempfindliches Aufzeichnungsmaterial.

(30) Priorität: **24.05.86 DE 3617499**

(43) Veröffentlichungstag der Anmeldung: **02.12.87 Patentblatt 87/49**

(45) Bekanntmachung des Hinweises auf die Patenterteilung: **30.03.94 Patentblatt 94/13**

(84) Benannte Vertragsstaaten: **DE GB**

(56) Entgegenhaltungen:
**EP-A- 0 152 819**
**DE-A- 3 246 037**
**GB-A- 2 133 899**
**US-A- 3 544 320**

**IBM TECHNICAL DISCLOSURE BULLETIN, Band 17, Nr. 1, Juni 1974, Seite 85, New York, US; G.T. ELIE et al.: "Photoresist cross-linked with a thermal free-radical initiator for use as an ion implant mask"**

**IBM TECHNICAL DISCLOSURE BULLETIN, Band 18, Nr. 3, August 1975, Seite 788, New York, US; J.M. MAYONE: "Vacuum bake photoresist preparation for high-energy, high-dose ion implantation"**

(73) Patentinhaber: **HOECHST AKTIENGESELLSCHAFT**
**D-65926 Frankfurt(DE)**

(72) Erfinder: **Pawlowski, Georg, Dr.**
**Blücherstrasse 48a**
**D-6200 Wiesbaden(DE)**
Erfinder: **Mohr, Dieter, Dr.**
**Mainstrasse 5**
**D-6229 Schlangenbad 5(DE)**
Erfinder: **Jung, Günter**
**Zum Schwimmbad 5**
**D-6204 Taunusstein 1(DE)**

**EP 0 247 461 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein lichtempfindliches Gemisch, das ein Diazoniumsalz-Polykondensationsprodukt und ein polymeres Bindemittel enthält und das insbesondere zur Herstellung von Druckplatten geeignet ist.

Aus der DE-A 20 24 244 (= US-A 3 867 147) ist es bekannt, lichtempfindliche Aufzeichnungsmaterialien aus Mischkondensationsprodukten von kondensationsfähigen Diazoniumsalzen und anderen nicht lichtempfindlichen kondensationsfähigen Verbindungen, gegebenenfalls in Kombination mit polymeren Bindemitteln, zur Herstellung von Druckplatten zu verwenden. Diese lichtempfindlichen Materialien zeichnen sich durch hohe Lichtempfindlichkeit und gute Druckauflagen aus. Die Auflage ist besonders hoch bei Verwendung von wasserunlöslichen Bindemitteln, z. B. Polyvinylformal, doch lassen sich solche Schichten nur mit solchen Entwicklern sauber verarbeiten, die einen erheblichen Anteil an flüchtigen organischen Lösungsmitteln enthalten.

Aus der DE-A 31 30 987 sind ähnliche Gemische bekannt, die als Bindemittel Styrol-Maleinsäureanhydrid-Mischpolymerisate enthalten und die sich mit rein wäßrigen alkalischen Lösungen entwickeln lassen. Diese Bindemittel haben in der Regel Säurezahlen weit über 100.

Die mit diesen Gemischen erhaltenen Druckplatten liefern jedoch geringere Druckauflagen als solche, die in wäßrigem Alkali unlösliche Bindemittel enthalten.

Aus der DE-A 30 36 077 sind ferner entsprechende Gemische bekannt, die als Bindemittel Polymere mit seitenständigen Alkenylsulfonylurethangruppen enthalten. Auch diese Gemische lassen sich mit rein wäßrigen Lösungen entwickeln. Bei der Verarbeitung zu Flachdruckplatten ergeben sie jedoch lichtgehärtete Schichten, deren Farbannahme nicht zufriedenstellend ist und deren Auflagenhöhe ebenfalls begrenzt ist.

In der EP-A 152 819 werden ähnliche Gemische beschrieben, die ein Diazoniumsalz-Polykondensationsprodukt und ein polymeres Umsetzungsprodukt aus einem Hydroxylgruppen enthaltenden Polymeren und intramolekularen Anhydriden von Polycarbonsäuren, bevorzugt Dicarbonsäuren, enthalten. Auch die aus diesen Gemischen hergestellten Aufzeichnungsmaterialien lassen sich mit wäßrig-alkalischen Lösungen entwickeln und zeichnen sich durch günstige kopier- und drucktechnische Eigenschaften, insbesondere durch eine gegenüber anderen wäßrig-alkalisch entwickelbaren Flachdruckplatten erhöhte Druckauflage aus.

Da grundsätzlich stets eine weitere Erhöhung der Druckauflagen angestrebt wird, hat man versucht, die Auflagenleistung von Flachdruckplatten durch zusätzliche Verarbeitungsmaßnahmen zu erhöhen.

In der DE-A 1 447 992 wird ein Verfahren zur Herstellung von Offsetdruckformen mit erhöhter Auflagenleistung beschrieben, bei dem die belichtete und entwickelte Druckform eine Zeitlang nacherhitzt wird, z. B. 20 Minuten auf 240° C. Dabei ist die Wirkung auf solche Schichten beschränkt, die als Bindemittel Novolake enthalten. Auch wird eine signifikante Verbesserung nur mit positiv arbeitenden Schichten auf Basis von Naphthochinondiaziden erzielt.

In der DE-A 32 46 037 sind lichtempfindliche Gemische beschrieben, die verschiedene positiv oder auch negativ arbeitende lichtempfindliche Verbindungen, alkalilösliche Bindemittel und ein thermisch aktivierbares Vernetzungsmittel enthalten. Als Vernetzungsmittel werden z. B. Hexamethylolmelamin und seine Methylether eingesetzt. Als lichtempfindliche, negativ arbeitende Verbindungen werden auch Diazoniumsalz-Polykondensationsprodukte genannt. Auch hier wird die beste Wirkung mit positiv arbeitenden Gemischen erzielt, und die Lagerfähigkeit der Gemische ist begrenzt.

In IBM Technical Disclosure Bulletin, Bd. 17, Nr. 1, Juni 1974, S. 85, wird der Zusatz von ca. 30 % Benzoylperoxid, bezogen auf Feststoff, zu positiv arbeitenden Photoresists beschrieben. Die entwickelte Resistmaske wird durch Erwärmen vernetzt und dadurch resistent gegen Ionenimplantation und saure Ätzmittel.

Gemäß der gleichen Veröffentlichung Band 18, Nr. 3, August 1975, S. 788, hat die dort beschriebene Nacherhitzung auf 210 °C ein unerwünschtes Fließen der Resistmaske zur Folge. Hier wird nun ein Erhitzen von 16 Stunden auf 125 °C im Vakuum emppfohlen. Diese für Photoresists vorgesehene Behandlung hat eine andere Aufgabe als das Einbrennen von Negativ-Druckplatten zur Erhöhung der Druckauflage. Im letzteren Fall kommt es vor allem auf mechanische Abriebfestigkeit während des Druckens an.

Aufgabe der Erfindung war es, ein lichtempfindliches Gemisch auf Basis von negativ arbeitenden Diazoniumsalz-Polykondensationsprodukten und polymeren Bindemitteln vorzuschlagen, das sich zu Flachdruckplatten verarbeiten läßt, deren Druckauflage durch Erhitzen bzw. Einbrennen nach dem Entwickeln wesentlich erhöhen läßt und dessen Lagerfähigkeit gegenüber bekannten Gemischen gleicher Art nicht verkürzt ist.

Erfindungsgemäß wird ein lichtempfindliches Gemisch vorgeschlagen, das als wesentliche Bestandteile ein Diazoniumsalz-Polykondensationsprodukt, ein polymeres Bindemittel und eine thermisch aktivierbare vernetzende Verbindung enthält.

Das erfindungsgemäße Gemisch ist dadurch gekennzeichnet, daß die vernetzende Verbindung in einer Menge von 0,1 bis 15 Gew.-%, bezogen auf die nichtflüchtigen Bestandteile des Gemisches, vorliegt und ein organisches Peroxid gemäß einer der allgemeinen Formeln I und II

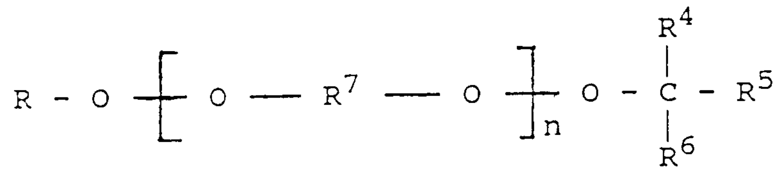 (I)

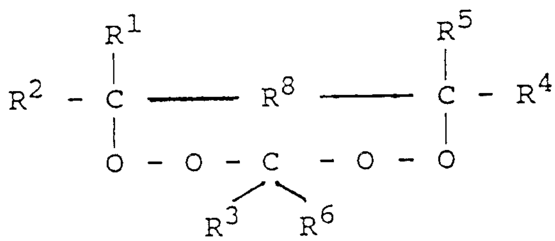 (II)

ist, worin

R eine Acylgruppe oder die Gruppe

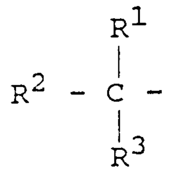 ,

$R^1$ bis $R^6$ gleiche oder verschiedene Alkyl-, Alkenyl-, Cycloalkyl-, Aralkyl- oder Arylreste bedeuten, wobei jeweils zwei an einem Kohlenstoffatom stehende Alkylreste zu einer Cycloalkylengruppe verbunden sein können,

$R^7$ eine Alkylen-, Cycloalkylen-, Alkenylen-, Alkinylen-, Aralkylen- oder Arylengruppe,

$R^8$ eine Einfachbindung oder eine Alkylengruppe und

n 0 oder 1 ist.

Erfindungsgemäß wird ferner ein lichtempfindliches Aufzeichnungsmaterial, insbesondere für die Herstellung von Flachdruckplatten, aus einem Schichtträger und einer lichtempfindlichen Schicht vorgeschlagen, die aus dem vorstehend beschriebenen lichtempfindlichen Gemisch besteht.

Erfindungsgemäß wird schließlich noch ein Verfahren zur Herstellung von Flachdruckformen vorgeschlagen, bei dem man ein lichtempfindliches Aufzeichnungsmaterial mit einer lichtempfindlichen Schicht auf Basis von Diazoniumsalz-Polykondensationsprodukten bildmäßig belichtet und entwickelt und danach auf erhöhte Temperatur erwärmt.

Das erfindungsgemäße Verfahren ist dadurch gekennzeichnet, daß man ein Aufzeichnungsmaterial der vorstehend angegebenen Beschaffenheit und Zusammensetzung einsetzt und das entwickelte Material kurze Zeit auf eine Temperatur oberhalb 120° C erwärmt.

In der Formel I ist R bevorzugt eine Gruppe der Formel $(R^1)(R^2)(R^3)C$; wenn R eine Acylgruppe ist, ist diese bevorzugt aromatisch.

Wenn $R^7$ eine aliphatische oder cycloaliphatische Gruppe oder eine über aliphatische Kohlenstoffatome gebundene Aralkylengruppe ist, so sind die an die Peroxygruppen gebundenen Kohlenstoffatome vorzugsweise tertiär.

Wenn die Reste $R^1$ bis $R^6$ Alkylgruppen sind, haben sie bevorzugt 1 bis 4 Kohlenstoffatome, wobei Methylgruppen besonders bevorzugt sind.

Von den Resten $R^1$ bis $R^6$ sind bevorzugt mindestens je zwei, die an einem Kohlenstoffatom stehen, Alkylgruppen.

Wenn $R^1$ bis $R^6$ Alkenylgruppen sind, haben sie vorzugs-weise 2 bis 4 Kohlenstoffatome; Cycloalkenylgruppen haben bevorzugt 5 bis 8, Aralkylgruppen 7 bis 10 und Arylgruppen 6 bis 10 Kohlenstoffatome.

Wenn $R^7$ eine Alkylengruppe ist, hat diese im allgemeinen 1 bis 12, bevorzugt 3 bis 12 Kohlenstoffatome; Alkenylen-und Alkinylengruppen haben im allgemeinen 2 bis 12, bevorzugt 4 bis 12 Kohlenstoffatome; Cycloalkylengruppen haben im allgemeinen 5 bis 10, Arylengruppen 6 bis 10 und Aralkylengruppen 7 bis 12 Kohlenstoffatome.

$R^8$ hat im allgemeinen 1 bis 8, bevorzugt 2 bis 4 Kohlenstoffatome.

Die Substituenten R und $R^1$ bis $R^6$ sowie die Gruppen $R^7$ und $R^8$ können reine Kohlenwasserstoffgruppen sein, d. h. unsubstituiert oder durch Alkylgruppen substituiert sein. Sie können auch als Substituenten Halogenatome, Alkoxy-, Acyl-, Acyloxy- oder Alkoxycarbonylgruppen enthalten.

Beispiele für bevorzugte Peroxide sind:

1,1-Bis-(t-butylperoxy)-trimethylcyclohexan,
n-Butyl-4,4-bis-(t-butylperoxy)valerat,
Ethyl-3,3-bis-(t-butylperoxy)butyrat,
Dicumylperoxid,
t-Butylcumylperoxid,
1,4-Bis-(t-butylperoxyisopropyl)benzol,
2,5-Dimethylhexan-2,5-di-t-butylperoxid,
Di-t-butylperoxid,
2,5-Dimethylhex-3-in-2,5-di-t-butylperoxid

sowie die entsprechenden Amylperoxide und für besondere Anwendungen noch

t-Butylperbenzoat sowie
Hexamethyl-tetraoxacyclononan.

Derartige Peroxide sind in vielen Fällen kommerziell erhältlich und liegen dann i. a. in phlegmatisierter Form, beispielsweise als Pasten in Siliconöl, als Pulver oder Granulate in Kreidemischungen oder Kunststoffmischungen vor. Ihr Anteil am Gemisch beträgt 0,1 bis 15 Gew.-%, bevorzugt 0,5 bis 10 Gew.-%, wobei die reine, nicht phlegmatisierte Wirksubstanz zugrunde gelegt wird und der Anteil auf die nichtflüchtigen Bestandteile des Gemischs bezogen ist.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten $A-N_2X$ leiten sich bevorzugt von Verbindungen der Formel $(R^{16}-R^{17}-)_pR^{18}-N_2X$ ab, wobei

- X das Anion der Diazoniumverbindung,
- p eine ganze Zahl von 1 bis 3,
- $R^{16}$ einen aromatischen Rest mit mindestens einer zur Kondensation mit aktiver Carbonylverbindung befähigten Position,
- $R^{18}$ eine ggf. substituierte Phenylengruppe,
- $R^{17}$ eine Einfachbindung oder eine der Gruppen:

  $-(CH_2)_q-NR^{19}-$,
  $-O-(CH_2)_r-NR^{19}-$,
  $-S-(CH_2)_r-NR^{19}-$,
  $-S-CH_2CO-NR^{19}-$,
  $-O-R^{20}-O-$,
  $-O-$
  $-S-$ oder
  $-CO-NR^{19}-$

bedeuten, worin

- q eine Zahl von 0 bis 5,
- r eine Zahl von 2 bis 5,
- $R^{19}$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- $R^{20}$ eine Arylengruppe mit 6 bis 12 C-Atomen ist.

Von den genannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponente B werden die gegebenenfalls substituierten Diphenylether, Diphenylsulfide, Diphenylmethane oder Diphenyle bevorzugt. Dabei werden für die Kondensation die Bis-methoxymethyl-, Bis-hydroxymethyl- oder Bis-acetoxymethyl-derivate der Grundkörper mit besonderem Vorteil eingesetzt. Das Kondensationsprodukt kann im Mittel 0,1 bis 50, bevorzugt 0,2 bis 20 Einheiten B je Einheit $A-N_2X$ enthalten.

Weitere besonders vorteilhafte Polykondensationsprodukte werden erhalten, indem ein ggf. substituiertes Diphenylamindiazoniumsalz zuerst mit einer aromatischen Verbindung $R'-O-CH_2-B$ und danach mit einer aromatischen Verbindung $R'-O-CH_2-B-CH_2-O-R'$ kondensiert wird, wobei R' ein Wasserstoffatom, ein Alkyl- oder aliphatischer Acylrest ist. Diese Kondensationsprodukte sind in der EP-A 126 875 beschrieben.

Die erfindungsgemäßen Gemische enthalten im allgemeinen 5 bis 80, bevorzugt 10 bis 70 Gew.-% Diazoniumverbindung.

Als polymere Bindemittel sind im wesentlichen alle bekannten Polymeren geeignet, die eine ausreichende Anzahl von aktiven, radikalisch abstrahierbaren, insbesondere tertiär gebundenen Wasserstoffatome enthalten und die mit den vorstehend beschriebenen Diazoniumsalz-Polykondensationsprodukten in den angegebenen Konzentrationsverhältnissen verträglich sind. Bevorzugt unter diesen sind jedoch Bindemittel, die in wäßrig-alkalischen Lösungen löslich oder zumindest quellbar sind.

Als geeignete Polymere seien genannt: Copolymere des Styrols oder substituierter Styrole mit ungesättigten Carbonsäuren, beispielsweise Copolymere des Styrols mit Crotonsäure oder Maleinsäureanhydrid, teilverseifte oder teilveresterte Copolymere des Styrols mit Maleinsäureanhydrid, Copolymere von Alkyl(meth)acrylaten mit ungesättigten Carbonsäuren, beispielsweise Terpolymere aus Hexylmethacrylat, Methylmethacrylat und Acrylsäure, Copolymere von Hydroxyalkyl(meth)acrylaten mit anderen ungesättigten (Meth)acrylaten oder mit Acrylnitril, Vinylacetatcopolymere, teilverseifte Vinylacetatcopolymere, Copolymere des Vinylalkohols, des Allyl-alkohols oder höherer ungesättigter Alkohole, Polyvinylacetale, Epoxidharze mit aliphatischen Einheiten, teilverseifte Epoxidharze, Polyurethane, Polyester, Polyether und ähnliche.

Bevorzugt werden Umsetzungsprodukte von Hydroxygruppen enthaltenden Polymeren, insbesondere Polyvinylacetalen, z. B. Polyvinylbutyralen, mit Sulfonylisocyanaten, Phosphinylisocyanaten, Dicarbonsäureanhydriden oder deren Mischungen.

Besonders bevorzugt werden die in der DE-A 34 04 366 beschriebenen polymeren Umsetzungsprodukte aus einem hydroxylgruppenhaltigen Polymeren und dem Anhydrid einer cyclischen Di- oder Tricarbonsäure, insbesondere einer Dicarbonsäure.

Derartige bevorzugte Bindemittel werden durch Umsetzen mit Säureanhydriden einer der Formeln I, II oder III

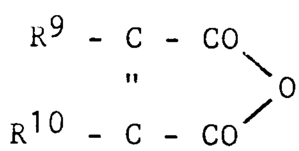 (I)

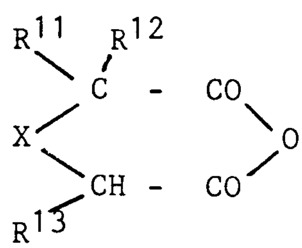 (II)

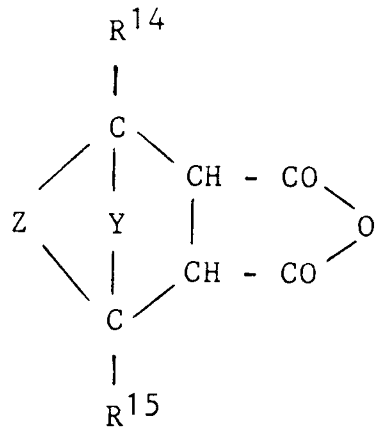

(III)

erhalten, worin

| | |
|---|---|
| $R^9$ und $R^{10}$ | einzeln Wasserstoff-, Halogenatome oder Alkylgruppen bedeuten oder miteinander zu einem aromatischen oder heteroaromatischen, gegebenenfalls substituierten und ggf. teilweise hydrierten 5- oder 6-gliedrigen Ring verbunden sind, an den bis zu zwei aromatische oder cycloaliphatische Ringe ankondensiert sein können, |
| $R^{11}$, $R^{12}$ und $R^{13}$ | einzeln Wasserstoffatome oder Alkylgruppen bedeuten oder |
| $R^{11}$ und $R^{13}$ | miteinander zu einem ggf. substituierten gesättigten oder ungesättigten aliphatischen Ring verbunden sind, der einschließlich X fünf oder sechs Ringglieder haben kann, |
| $R^{14}$ und $R^{15}$ | Wasserstoffatome oder Alkylgruppen, |
| X | eine Einfachbindung, eine 1,1-Alkylengruppe, eine 1,1-Cycloalkylengruppe, die ggf. substituiert sind, ein Sauerstoff- oder Schwefelatom, |
| Y | ein Sauerstoff- oder Schwefelatom, eine 1,1- oder 1,2-Alkylengruppe oder eine 1,2-Alkenylengruppe, an die ggf. ein aromatischer oder cycloaliphatischer Ring ankondensiert ist, und |
| Z | die zur Vervollständigung eines gesättigten oder ungesättigten ggf. substituierten Rings erforderlichen Ringglieder bedeuten, wobei an diesen Ring bis zu zwei aromatische oder cycloaliphatische Ringe ankondensiert sein können. |

Wenn die Reste $R^9$ bis $R^{15}$ Alkylgruppen bedeuten, haben diese im allgemeinen 1 bis 4, bevorzugt 1 bis 2 Kohlenstoffatome. Substituenten, die an die aromatischen oder cycloaliphatischen Ringe gebunden sein können, sind z.B. Alkylgruppen, Alkoxygruppen, Halogenatome, Nitrogruppen oder Carboxylgruppen.

Besonders bevorzugt werden die Reaktionsprodukte mit Malein-, Chlormalein-, Dichlormalein-, Phthal-, Trimellith-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht. Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet.

Das Molekulargewicht der Bindemittel kann innerhalb weiter Bereiche variieren. Im allgemeinen werden Bindemittel mit mittleren Molekulargewichten zwischen 5.000 und etwa 200.000 und darüber, vorzugsweise zwischen 10.000 und 100.000 eingesetzt. Die Säurezahl der Bindemittel kann im allgemeinen zwischen 5 und 200, bevorzugt zwischen 15 und 100 liegen. Der Mengenanteil an Bindemittel liegt im allgemeinen bei 20 bis 95, vorzugsweise 25 bis 85 Gew.-%, bezogen auf die nichtflüchtigen Anteile des Gemischs.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Netzmittel, Verlaufmittel, Haftvermittler, Farbstoffe, Pigmente und Farbbildner zugesetzt werden.

Art und Menge dieser Zusätze richten sich nach dem für das lichtempfindliche Gemisch vorgesehenen Anwendungsgebiet.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d. h. die Bestandteile der nach dem Verdampfen des Lösemittels erhaltenen festen lichtempfindlichen Schicht.

| | | | | |
|---|---|---|---|---|
| Bindemittel | : | 30 | bis | 90 % |
| Diazoniumsalz-Polykondensationsprodukt | : | 10 | bis | 70 % |
| Peroxid | : | 0,5 | bis | 10 % |
| Säure | : | 0 | bis | 10 % |
| Farbstoff oder Pigment | : | 0 | bis | 12 % |
| Belichtungskontrastgeber (Farbstoff) | : | 0 | bis | 5 % |

Die Beschichtung des Trägermaterials erfolgt aus entsprechenden organischen Lösemitteln oder Lösemittelgemischen, und zwar im allgemeinen durch Gießen, Sprühen oder Eintauchen. Als Lösemittel sind Alkohole, Ketone, Ester, Ether und dergleichen geeignet. Als günstige Lösemittel haben sich dabei die Partialether der Glykole oder der Ketoalkohole erwiesen, z. B. Ethylenglykolmonomethylether.

Als Schichtträger eignen sich z. B. Magnesium, Zink, Kupfer, Kupfer/Chrom, Messing/Chrom, mechanisch, chemisch und elektrochemisch aufgerauhtes Aluminium, anodisiertes Aluminium, Stahl, verchromter Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden. Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Besonders bevorzugt wird das Gemisch zur Herstellung von Flachdruckformen verwendet, wobei als Trägermaterial Aluminium bevorzugt wird. Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Gemische lassen sich auch in der Photoresisttechnik einsetzen, z. B. zur Herstellung von Hoch-, Tief- oder Mehrmetalldruckplatten oder von gedruckten Schaltungen. Bei diesen Anwendungen ist in vielen Fällen die erhöhte Schichtresistenz gegenüber den sonst verwendeten photopolymerisierbaren Gemischen von Vorteil.

Bei allen Anwendungen tritt insbesondere die nach der thermischen Nachhärtung deutlich erhöhte Resistenz gegenüber Lösungsmitteln, lösungsmittelhaltigen Farben, und, sofern die Bindemittel saure Funktionen aufweisen, auch gegenüber wäßrig-alkalischen oder organischalkalischen Flüssigkeiten und Reagenzien sowie solchen wäßrigen oder alkoholischen Mischungen, die Netzmittel und/oder organische oder anorganische Säuren enthalten, vorteilhaft in Erscheinung.

Bei Verwendung der erfindungsgemäßen Gemische für Flachdruckformen besticht weiterhin die deutlich erhöhte Abriebfestigkeit, die es in einzelnen Fällen gestattet, die Lebensdauer der Schicht durch Nachhärten um ein Mehrfaches zu erhöhen; im allgemeinen wird eine Erhöhung der Abriebfestigkeit auf mindestens das Doppelte beobachtet. Dabei liegt der Vorteil des erfindungsgemäßen thermisch nachhärtbaren Gemischs darin, daß die Erhöhung der Abriebfestigkeit in Abhängigkeit vom gewählten Peroxid bereits bei niedrigeren Temperaturen erzielt werden kann, als es bislang üblich war. Andererseits können die Peroxide so ausgewählt werden, daß eine Vorvernetzung bei Raumtemperatur oder den gewählten Verarbeitungsbedingungen nicht gegeben ist.

Es war dabei überraschend, daß die erfindungsgemäßen Gemische in der beschriebenen Art thermisch nachhärtbar sind, da eine Vernetzung der Schichtbestandteile durch Peroxide, die als Polymerisationskatalysatoren bekannt sind, nicht zu erwarten war, insbesondere dann nicht, wenn die Hauptbestandteile der Schicht gesättigte Verbindungen sind. Die Peroxid enthaltenden Gemische lassen sich durch Nacherhitzen

wirksamer härten als bekannte Gemische mit z. B. Hexamethoxymethylmelamin als Vernetzer. Sie weisen überraschenderweise auch eine bessere Lagerfähigkeit bei Normaltemperatur als diese bekannten Gemische auf.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 $\mu$m emittieren, oder YAG-Laser, die bei 1,06 $\mu$m emittieren.

Als Entwicklerlösungen werden neutrale oder alkalische wäßrige Lösungen mit einem pH-Wert im Bereich von 6 bis 14, vorzugsweise 7,5 bis 12, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösungsmitteln enthalten. Bevorzugt werden schwerflüchtige Lösungsmittel, z.B. araliphatische Alkohole, deren Dampfdruck bei der Handhabung des Entwicklers nicht ins Gewicht fällt.

Die Entwicklung kann in bekannter Weise durch Tauchen, Besprühen, Bürsten oder Tamponieren erfolgen.

Die derart entwickelte Druckplatte kann erfindungsgemäß noch durch thermisches Nachhärten in ihrer Abriebfestigkeit verbessert werden. Zu diesem Zweck wird sie bevorzugt auf eine Temperatur zwischen 120 und 240° C erwärmt. Es ist von Vorteil, wenn die Platte vor dieser Behandlung mit einer geeigneten Einbrenngummierung behandelt wird, um eine Verschmutzung des Hintergrunds zu vermeiden. Bei Verwendung von Peroxiden mit verhältnismäßig niedriger Scorch-Temperatur kann man auf eine Gummierung jedoch auch verzichten, da in derartigen Fällen nicht mit einer Verunreinigung durch kondensierende Schichtbestandteile zu rechnen ist. Der besondere Vorteil des erfindungsgemäßen Gemischs liegt darin, daß das Einbrennen stark verkürzt - im allgemeinen auf 0,3 bis 10 Minuten, bevorzugt auf 0,5 bis 5 Minuten - und bei deutlich reduzierten Vernetzungstemperaturen - im allgemeinen zwischen 120 und 240° C, vorzugsweise zwischen 140 und 230° C - durchgeführt werden kann. Ein weiterer Vorteil ist darin zu sehen, daß sich auch solche Gemische durch einen Wärmeschritt nachhärten lassen, die an sich keine vernetzenden oder vernetzbaren Gruppen mehr aufweisen. So lassen sich auch durchbelichtete Diazoniumsalz-Polykondensationsprodukte in einem inerten Bindemittel zusätzlich weitervernetzen und in ihrer Abriebbeständigkeit deutlich verbessern.

Die nachstehenden Beispiele beschreiben die Herstellung der erfindungsgemäßen lichtempfindlichen Gemische und der mit diesen hergestellten Aufzeichnungsmaterialien. In den Beispielen stehen Gewichtsteile (Gt) und Volumteile (Vt) zueinander im Verhältnis von g zu ml. Prozentangaben sind, wenn nichts anderes angegeben ist, Gewichtsprozente, Temperaturen sind in Grad C ange-geben. Alle Druckversuche wurden bei verstärktem Anpreßdruck der Maschinen und unter Verwendung abriebfördernder Farben durchgeführt.

Beispiel 1

Eine Beschichtungslösung aus
62 Gt des Umsetzungsprodukts eines Polyvinylbutyrals mit einem Molekulargewicht von 70.000 bis 80.000, das 71 Gew.-% Vinylbutyral-, 2 Gew.-% Vinylacetat- und 27 Gew.-% Vinylalkoholeinheiten enthält, mit Bernsteinsäureanhydrid (Säurezahl des Produkts 42),
21 Gt eines Diazoniumsalz-Polykondensationsprodukts, hergestellt aus 1 mol 3-Methoxy-diphenylamin-4-diazoniumsulfat und 1 mol 4,4'-Bis-methoxymethyl-diphenylether in 85%iger Phosphorsäure und isoliert als Mesitylensulfonat,
2,4 Gt45 %iges 2,5-Dimethylhexan-2,5-di-t-butyl-peroxid als Granulat mit Kreide (INTEROX DHBP-45-IC/G der Fa. Peroxid-Chemie GmbH),
2,5 Gt Phosphorsäure (85 %),
3 Gt Viktoriareinblau FGA (C.I.Basic Blue 81) und
0,7 Gt Phenylazodiphenylamin in
2570 Gt 2-Methoxy-ethanol und
780 Gt Tetrahydrofuran

wird auf eine Aluminiumfolie, welche elektrolytisch aufgerauht und anodisiert und danach mit einer 0,1 %igen wässrigen Lösung von Polyvinylphosphonsäure vorbehandelt worden ist, aufgebracht und anschließend getrocknet.

Die so erhaltene Kopierschicht, die ein Schichtgewicht von 1,1 g/m$^2$ aufweist, wird unter einer Negativvorlage 30 Sekunden mit einer Metallhalogenid-Lampe von 5 kW Leistung belichtet.

Eine weitere Druckplatte wird in gleicher Weise hergestellt und belichtet.

Die belichteten Schichten werden mit einer Entwickler-Lösung folgender Zusammensetzung

2,9 Gt Natriumoctylsulfat,
0,2 Gt Natriummetasilikat x 9 Wasser,
3,5 Gt Trinatriumphosphat x 12 Wasser,
3,9 Gt Dinatriumhydrogenphosphat x 12 Wasser und
1,5 Gt Kaliumtetraborat x 4 Wasser in
88 Gt Wasser

mittels eines Plüschtampons behandelt, wobei die nichtbelichteten Schichtbereiche innerhalb weniger Sekunden sauber entfernt werden, und anschließend mit Wasser abgespült und getrocknet.

In den Kopien ist die Stufe 4 eines Silberfilm-Halbtonstufenkeils mit einem Dichteumfang von 0,15 bis 1,50, wobei die Dichteinkremente 0,15 betragen, noch voll gedeckt.

Eine der beiden Druckplatten wird in einem auf 200° C erhitzten Umluftschrank 5 Minuten gelagert und anschließend abkühlen gelassen.

Die beiden Druckformen werden nebeneinander in eine Bogenoffsetmaschine eingespannt. Während die nicht nachgehärtete Platte ab etwa 140.000 Drucke Schädigungen in den Rasterflächen und eine schlechtere Farbannahme in den Volltonflächen zeigt, druckt die eingebrannte erfindungsgemäß thermisch nachbehandelte Platte bei einer Auflage von 260.000 Drucken noch einwandfrei.

Beispiel 2

Eine Beschichtungslösung aus

35,1 Gt des Umsetzungsproduktes des in Beispiel 1 beschriebenen Polyvinylbutyrals mit Maleinsäureanhydrid (Säurezahl des Produkts 30),
23,4 Gt des in Beispiel 1 angegebenen Diazoniumsalz-Kondensationsprodukts,
2,0 Gt Di-t-butylperoxid (INTEROX DTB der Fa. Peroxid Chemie GmbH) als technisch reine Flüssigkeit,
2,1 Gt Phosphorsäure (85 %),
1,5 Gt Viktoriareinblau FGA und
1,1 Gt Phenylazodiphenylamin in
1900 Gt 2-Methoxy-ethanol

wird auf eine Aluminiumfolie, welche durch Bürsten mit einer wässrigen Schleifmittelsuspension aufgerauht und danach mit einer 0,1 %igen wässrigen Lösung von Polyvinylphosphonsäure vorbehandelt worden ist, zu einem Trockenschichtgewicht von 0,98 g/m$^2$ aufgebracht und 2 Minuten bei 100° C getrocknet.

Nach bildmäßiger Belichtung und Entwicklung von zwei Mustern dieser Platte mit der in Beispiel 1 beschriebenen Entwicklerlösung erhält man Kopien mit sehr hoher Auflösung und steiler Gradation. Die entwickelten Platten werden mit einer handelsüblichen Einbrenngummierung überwischt und getrocknet. Die eine Platte wird 2 Minuten auf 210° C erwärmt.

Nach dem Einspannen in eine Bogenoffsetmaschine werden mit der nicht nacherwärmten Platte etwa 35.000 Bogen, mit der nacherwärmten Platte ca. 85.000 Bogen einwandfreier Qualität erzielt.

Beispiel 3

Eine Beschichtungslösung der folgenden Zusammensetzung

15,7 Gt des Umsetzungsprodukts aus dem in Beispiel 1 beschriebenen Polyvinylbutyral und Phthalsäureanhydrid, das eine Säurezahl von 45 hat,
15,7 Gt des in Beispiel 1 beschriebenen Diazoniumsalz-Polykondensationsprodukts,
1,2 Gt Dicumylperoxid (INTEROX DCUP-40-G der Fa. Peroxid-Chemie GmbH) als 40 %iges Granulat mit Kreide,
1,0 Gt Phosphorsäure (85 %),
1,2 Gt Renolblau B2G-H (C.I. 74160) und
0,2 Gt Phenylazodiphenylamin in
1200 Gt 2-Methoxy-ethanol

wird auf den in Beispiel 1 verwendeten Schichtträger aufgebracht. Eine weitere Platte wird in gleicher

Weise, aber unter Fortlassung des Dicumylperoxids hergestellt.

Die Entwicklung erfolgt mit dem in Beispiel 1 angegebenen Entwickler. Die derart erhaltenen Kopien zeigen keinen Unterschied bezüglich Tonwert und Lichtempfindlichkeit, d. h. daß der Peroxid-Zusatz keinen Einfluß auf die kopiertechnischen Eigenschaften der Druckplatte nimmt.

Nach der Entwicklung wird je ein Muster der beiden sich durch den Peroxid-Zusatz unterscheidenden Platten 5 Minuten auf 180° C erhitzt.

Es werden in folgender Reihenfolge vier unterschiedlich bereitete bzw. behandelte Druckplatten nebeneinander eingespannt:

Platte a: Vergleichsschicht ohne Peroxid, ungehärtet,
Platte b: Vergleichsschicht ohne Peroxid, thermisch nachgehärtet,
Platte c: erfindungsgemäße Schicht, thermisch nachgehärtet,
Platte d: erfindungsgemäße Schicht, ungehärtet

Mit den Platten a und d werden Druckauflagen um 125.000 Drucke erhalten, wobei auch drucktechnisch kein eindeutiger Unterschied festzustellen ist.

Die Platte b ergibt eine Druckauflage von etwa 180.000 Drucken. Bei dieser Auflage wird eine deutliche Unruhe im Rasterfeld beobachtet. Die Platte c hingegen druckt bis zum Druckabbruch bei 225.000 Drucken ohne sichtbare Qualitätseinbuße.

Beispiel 4

Mit den in Beispiel 3 beschriebenen erfindungsgemäßen Druckplatten mit Peroxid-Zusatz und den entsprechenden Vergleichsplatten ohne Peroxid-Zusatz wird ein Lagertest durchgeführt.

Dazu werden je 5 Platten der beiden Einstellungen hergestellt. Von jeder Einstellung wird zunächst nach bildmäßiger Belichtung eine Probeentwicklung durchgeführt. Beide Platten zeigen kopiertechnisch identische Eigenschaften. Die restlichen Platten werden je 1 bis 4 Stunden in einem Heizschrank bei 100° C gelagert, abkühlen gelassen, bildmäßig belichtet und entwickelt.

Für die erfindungsgemäßen Platten werden in allen Fällen die gleichen Entwicklungsergebnisse erhalten wie für die Vergleichsplatten. Das heißt, daß die Lagerfähigkeit der erfindungsgemäßen Druckplatten durch den Peroxid-Zusatz nicht signifikant verschlechtert wird und die Platten längere Zeit höhere Temperaturen, beispielsweise bei unsachgemäßer Lagerung, vertragen.

Beispiel 5

Es wird eine Beschichtungslösung aus folgenden Bestandteilen hergestellt:

30,3 Gt des Umsetzungsprodukts aus dem in Beispiel 1 beschriebenen Polyvinylbutyral und Propylsulfonylisocyanat mit der Säurezahl 132,
15,1 Gt des in Beispiel 1 beschriebenen Diazoniumsalz-Polykondensationsprodukts,
1,5 Gt 1,4-Bis-(t-butylperoxy-isopropyl)benzol (INTEROX DIPP-2 der Fa. Peroxid-Chemie GmbH) als technisch reine Schuppen,
1,2 Gt Phosphorsäure (85 %),
1,1 Gt Phenylazodiphenylamin und
1,5 Gt Viktoriareinblau FGA in
1600 Gt 2-Methoxy-ethanol.

Nach Beschichtung, Trocknung und Belichtung wird mit einem Entwickler folgender Zusammensetzung verarbeitet:

5 Gt Natriumlaurylsulfat,
3 Gt Natriummetasilikat x 5 $H_2O$,
92 Gt Wasser.

Eine der erhaltenen Druckplatten wird 5 Minuten auf 180° C erwärmt und dann in einer Druckmaschine gegen eine nicht gehärtete Druckplatte gleicher lichtempfindlicher Zusammensetzung gedruckt. Als Druckfarbe wird eine handelsübliche UV-härtbare Farbe verwendet. Mit der nicht nacherwärmten Druckplatte werden maximal ca. 56.000 Drucke erzielt, während die erfindungsgemäße Druckplatte zu diesem Zeitpunkt keinerlei Schädigung aufweist.

Beispiel 6

Eine Beschichtungslösung aus

35,1 Gt des Umsetzungsprodukts eines Polyvinylbutyrals mit einem Molekulargewicht von etwa 70.000 bis

80.000, das 86 Gew.-% Vinylbutyral-, 2 Gew.-% Vinylacetat- und 12 Gew.-% Vinylalkoholeinheiten enthält, mit 3-Oxaglutarsäureanhydrid (Säurezahl 43),
23,4 Gt eines Diazoniumsalz-Kondensationsprodukts, hergestellt durch Kondensieren von 1 mol 3-Methoxy-diphenylamin-4-diazoniumsulfat mit 1 mol 4-Methyl-4′-methoxymethyl-diphenylether und anschließend mit 1 mol 4,4′-Bis-methoxymethyl-diphenylether in 85 %iger Phosphorsäure und isoliert als Mesitylensulfonat,
2,5 Gt 2,5-Dimethyl-hexan-2,5-di-t.-butylperoxid (INTEROX DHBP der Peroxid-Chemie GmbH) als 45 %iges Granulat mit Kreide,
2,1 Gt Phosphorsäure (85 %),
1,5 Gt Kristallviolett und
1,1 Gt Phenylazodiphenylamin in
1600 Gt 2-Methoxy-ethanol und
350 Gt Butanon
wird auf den in Beispiel 1 angegebenen Schichtträger zu einem Trockenschichtgewicht von 1,04 $g/m^2$ aufgebracht.

Nach bildmäßiger Belichtung und Entwicklung mit der in Beispiel 1 beschriebenen Entwicklerlösung erhält man eine Kopie mit sehr hoher Auflösung und steiler Gradation.

Danach wird die erhaltene Druckform 3 Minuten auf 210° C nacherwärmt. In einer Bogenoffsetmaschine werden deutlich mehr als 280.000 qualitativ einwandfreier Drucke erzielt.

Beispiel 7

Die im Beispiel 6 beschriebenen unbelichteten Druck-platten werden in einem Tropenschrank, der eine relative Feuchtigkeit von 60 % und eine Temperatur von 42° C aufweist, eine, zwei, fünf, zehn und zwanzig Wochen aufbewahrt. Nach der jeweiligen Entnahme aus dem Schrank werden die Muster wie im vorhergehenden Beispiel belichtet und entwickelt. Selbst bei der zwanzig Wochen im Tropenschrank gelagerten Platte läßt sich weder in der Kopie noch im Druck ein Unterschied zu der Originalplatte des Beispiels 6 erkennen.

Es läßt sich daher feststellen, daß durch den Peroxidzusatz unter Tropenbedingungen keine Einschränkung der Lagerfähigkeit erfolgt.

Beispiel 8

Die in Beispiel 6 beschriebenen unbelichteten Druckplatten werden in einem Wärmeschrank (Hotbox), der eine Temperatur von 56° C aufweist, zwei, sechs, dreizehn und sechsundzwanzig Wochen aufbewahrt. Nach der jeweiligen Entnahme wird wie im Beispiel 7 beschrieben verfahren. Auch hier wird beobachtet, daß die sechsundzwanzig Wochen gelagerte Druckplatte weder in der Kopie noch im Druck einen signifikanten Unterschied zu der Originalplatte des Beispiels 6 aufweist. Es läßt sich somit feststellen, daß erhöhte Temperaturen, wie sie gelegentlich bei unsachgemäßer Lagerung auftreten können, zu keiner sichtbaren Einschränkung der Lagerfähigkeit führen.

Beispiel 9

In einem umfassenden Versuch werden drei Beschichtungs-lösungen folgender Zusammensetzung hergestellt:
62 Gt des in Beispiel 1 beschriebenen polymeren Umsetzungsprodukts,
62 Gt des in Beispiel 1 beschriebenen Diazoniumsalz-Polykondensationsprodukts,
3 Gt einer der nachstehend beschriebenen Substanzen a), b) und c),
2,5 Gt Phosphorsäure (85 %),
3 Gt Viktoriareinblau FGA und
0,8 Gt Phenylazodiphenylamin in
3200 Gt 2-Methoxy-ethanol.

Bei den näher zu bezeichnenden Substanzen handelt es sich um
a) zermahlene Kreide,
b) n-Butyl-4,4-bis(t-butylperoxy)valerat (INTEROX NBV-40-IC/G der Fa. Peroxid-Chemie GmbH) als 40 %iges Pulver mit Kreide,
c) Bis(t-butylperoxy-isopropyl)benzol (INTEROX DIPP 40-IC/G der Fa. Peroxid-Chemie GmbH) als 40 %iges Pulver mit Kreide.

Die Lösungen werden auf mit Salpetersäure elektrolytisch aufgerauhte, anodisierte und mit Polyvinylphosphonsäure nachbehandelte Aluminiumplatten zu einem Trockenschichtgewicht von 1,0 g/m² aufgetragen.

Von jeder Einstellung werden 5 Platten hergestellt. Diese werden wie in Beispiel 1 beschrieben belichtet und entwickelt und dann mit einer Einbrenngummierung behandelt.

Von jeder Einstellung wird je eine Platte

1) nicht nachgehärtet,
2) 5 Minuten auf 150° C nacherwärmt,
3) 5 Minuten auf 180° C nacherwärmt,
4) 5 Minuten auf 210° C nacherwärmt und
5) 5 Minuten auf 240° C nacherwärmt.

Jeweils drei Platten a), b) und c), die die gleiche thermische Nachbehandlung erfahren haben, werden in eine Druckmaschine mit außerordentlich hohem Anpreßdruck gespannt.

Es werden folgende Ergebnisse erhalten:

1) Auflagen von a), b) und c) sind praktisch identisch.
2) Auflagen von a) und c) liegen im Bereich des Versuchs 1; Einstellung b) zeigt bei gleicher Auflage noch keine Schädigung.
3) Auflage von a) etwa 15 % höher als in Versuch 1; Einstellungen b) und c) zeigen bei dieser Auflage noch keine feststellbaren Schädigungen.
4) Auflage von a) etwa 15 % höher als in Versuch 1; b) und c) zeigen auch nach 50 % höherer Auflage noch keinerlei Schädigung.
5) Auflage von a) sinkt gegenüber Versuch 1 geringfügig ab; Einstellungen b) und c) sind auch nach 50 % höherer Auflage noch nicht geschädigt.

Dieses Beispiel zeigt, daß lichtempfindliche Schichten, die Diazoniumsalz-Polykondensationsprodukte enthalten, ohne den Zusatz geeigneter Vernetzungsmittel in ihrer Abriebfestigkeit nur geringfügig durch eine thermische Nachhärtung verbesserbar sind. Im vorliegenden Fall wird bei hohen Temperaturen sogar eine Erniedrigung der Druckauflage für die Schichten ohne Peroxid gefunden.

Dagegen sind die Peroxid enthaltenden Druckplatten - je nach Art des gewählten Peroxids - bereits bei tieferen Temperaturen und mit höherer Effizienz einbrennbar. Diese Einbrennbarkeit ist auch noch bei höheren Temperaturen gewährleistet.

## Patentansprüche

**1.** Lichtempfindliches Gemisch, das als wesentliche Bestandteile ein Diazoniumsalz-Polykondensationsprodukt, ein polymeres Bindemittel und eine thermisch aktivierbare vernetzende Verbindung enthält, dadurch gekennzeichnet, daß die vernetzende Verbindung in einer Menge von 0,1 bis 15 Gew.-%, bezogen auf die nichtflüchtigen Bestandteile des Gemisches, vorliegt und ein organisches Peroxid gemäß einer der allgemeinen Formeln I und II

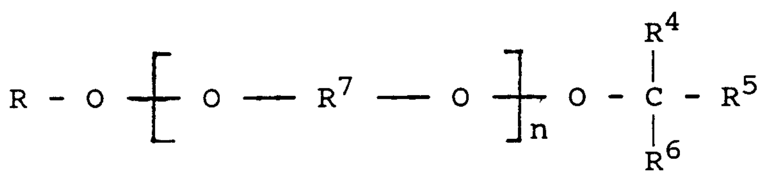

(I)

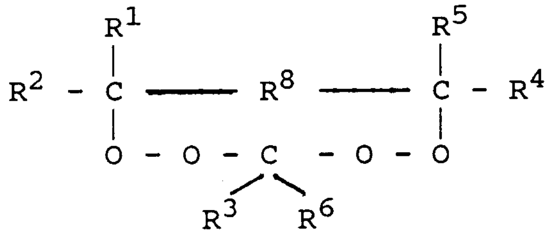

(II)

ist, worin

| | |
|---|---|
| R | eine Acylgruppe oder die Gruppe |

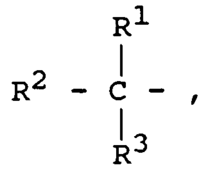

| | |
|---|---|
| $R^1$ bis $R^6$ | gleiche oder verschiedene Alkyl-, Alkenyl-, Cycloalkyl-, Aralkyl- oder Arylreste bedeuten, wobei jeweils zwei an einem Kohlenstoffatom stehende Alkylreste zu einer Cycloalkylengruppe verbunden sein können, |
| $R^7$ | eine Alkylen-, Cycloalkylen-, Alkenylen-, Alkinylen-, Aralkylen- oder Arylengruppe, |
| $R^8$ | eine Einfachbindung oder eine Alkylengruppe und |
| n | 0 oder 1 ist. |

**2.** Lichtempfindliches Gemisch nach Anspruch 1, dadurch gekennzeichnet, daß die Kohlenstoffatome von $R^7$, die an die Peroxygruppen gebunden sind, tertiäre aliphatische Kohlenstoffatome sind.

**3.** Lichtempfindliches Gemisch nach Anspruch 1, dadurch gekennzeichnet, daß die Reste $R^1$, $R^2$, $R^4$ und $R^5$ Alkylgruppen mit 1 bis 4 Kohlenstoffatomen sind.

**4.** Lichtempfindliches Gemisch nach Anspruch 1, dadurch gekennzeichnet, daß das polymere Bindemittel wasserunlöslich und in wäßrig-alkalischen Lösungen löslich oder quellbar ist.

**5.** Lichtempfindliches Gemisch nach Anspruch 4, dadurch gekennzeichnet, daß das polymere Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

**6.** Lichtempfindliches Gemisch nach Anspruch 5, dadurch gekennzeichnet, daß das synthetische Polymere ein Polyvinylacetal oder Polyvinylacetat mit freien Hydroxylgruppen ist.

**7.** Lichtempfindliches Gemisch nach Anspruch 5, dadurch gekennzeichnet, daß die organische Polycarbonsäure eine Di- oder Tricarbonsäure ist.

**8.** Lichtempfindliches Gemisch nach Anspruch 1, dadurch gekennzeichnet, daß das Diazoniumsalz-Polykondensationsprodukt aus wiederkehrenden Einheiten $A-N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

**9.** Lichtempfindliches Gemisch nach Anspruch 1, dadurch gekennzeichnet, daß es 5 bis 80 Gew.-% Diazoniumsalz-Polykondensationsprodukt und 20 bis 95 Gew.-% polymeres Bindemittel enthält.

**10.** Lichtempfindliches Aufzeichnungsmaterial mit einem Schichtträger und einer lichtempfindlichen Schicht, dadurch gekennzeichnet, daß die lichtempfindliche Schicht aus einem Gemisch gemäß Anspruch 1 besteht.

**11.** Verfahren zur Herstellung von Flachdruckformen, bei dem man ein lichtempfindliches Aufzeichnungsmaterial mit einer lichtempfindlichen Schicht auf Basis von Diazoniumsalz-Polykondensationsprodukten bildmäßig belichtet und entwickelt und danach auf erhöhte Temperatur erwärmt, dadurch gekennzeichnet, daß man ein Aufzeichnungsmaterial gemäß Anspruch 10 einsetzt und das entwickelte Material kurze Zeit auf eine Temperatur oberhalb 120° C erwärmt.

**12.** Verfahren nach Anspruch 11, dadurch gekennzeichnet, daß man das Material auf eine Temperatur im Bereich von 140 bis 230° C erwärmt.

**13.** Verfahren nach Anspruch 11, dadurch gekennzeichnet, daß man das Material 0,3 bis 10 Minuten erwärmt.

**Claims**

**1.** A light-sensitive mixture which contains, as the essential constituents, a diazonium salt polycondensation product, a polymeric binder and a crosslinking compound which can be activated thermally, characterized in that the cross-linking compound is present in an amount of 0.1 to 15 % by weight, relative to the non-volatile constituents, is an organic peroxide of one of the formulae I and II

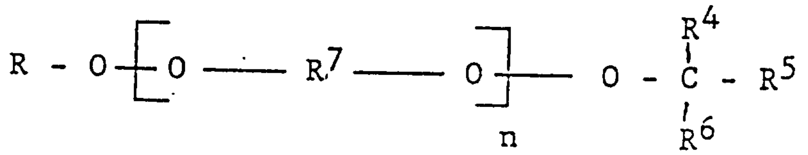
(I)

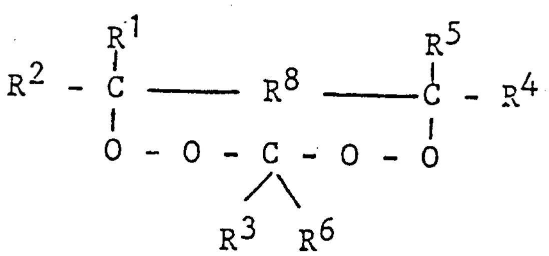
(II)

in which

| | |
|---|---|
| R | is an acyl group or a group |

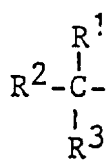
,

| | |
|---|---|
| $R^1$ to $R^6$ | are identical or different alkyl, alkenyl, cycloalkyl, aralkyl or aryl radicals, it being possible for any two alkyl radicals in position on one carbon atom to be linked to form a cycloalkylene group, |
| $R^7$ | is an alkylene, cycloalkylene, alkenylene, alkynylene, aralkylene or arylene group, |
| $R^8$ | is a single bond or an alkylene group and |
| n | is 0 or 1. |

**2.** A light-sensitive mixture as claimed in claim 1, characterized in that the carbon atoms of $R^7$, to which the peroxy groups are bonded, are tertiary aliphatic carbon atoms.

**3.** A light-sensitive mixture as claimed in claim 1, characterized in that the radicals $R^1$, $R^2$, $R^4$ and $R^5$ are alkyl groups having 1 to 4 carbon atoms.

**4.** A light-sensitive mixture as claimed in claim 1, characterized in that the polymeric binder is insoluble in water and soluble or swellable in aqueous-alkaline solutions.

5. A light-sensitive mixture as claimed in claim 4, characterized in that the polymeric binder is a reaction product of an intramolecular anhydride of an organic polycarboxylic acid with a synthetic polymer which contains hydroxyl groups but no other functional groups capable of reaction with acid anhydrides.

6. A light-sensitive mixture as claimed in claim 5, characterized in that the synthetic polymer is a polyvinyl acetal or polyvinyl acetate having free hydroxyl groups.

7. A light-sensitive mixture as claimed in claim 5, characterized in that the organic polycarboxylic acid is a dicarboxylic or tricarboxylic acid.

8. A light-sensitive mixture as claimed in claim 1, characterized in that the diazonium salt polycondensation product comprises recurrent units $A\text{-}N_2X$ and B which are mutually linked by bridge members, preferably methylene groups, which are derived from carbonyl compounds capable of condensation, A being the radical of an aromatic diazonium compound capable of condensation with formaldehyde and B being the radical of a compound free of diazonium groups and capable of condensation with formaldehyde, in particular of an aromatic amine, of a phenol, phenol ether, aromatic thioether, aromatic hydrocarbon, aromatic heterocyclic compound or of an organic acid amide.

9. A light-sensitive mixture as claimed in claim 1, characterized in that it contains 5 to 80 % by weight of diazonium salt polycondensation product and 20 to 95 % by weight of polymeric binder.

10. A light-sensitive recording material comprising a layer support and a light-sensitive layer, characterized in that the light-sensitive layer is comprised of a mixture as claimed in claim 1.

11. A process for the preparation of planographic printing forms, wherein a light-sensitive recording material with a light-sensitive layer based on diazonium salt polycondensation products is exposed imagewise and developed and then heated to an elevated temperature, characterized in that a recording material as claimed in claim 10 is used, and the developed material is heated for a short time to a temperature above 120° C.

12. The process as claimed in claim 11, characterized in that the material is heated to a temperature in the range from 140 to 230° C.

13. The process as claimed in claim 11, characterized in that the material is heated for 0.3 to 10 minutes.

**Revendications**

1. Mélange photosensible contenant, comme composants principaux, un produit de polycondensation de sel de diazonium, un liant polymère et un composé réticulant qu'il est possible d'activer par voie thermique, caractérisé en ce que le composé réticulant est présent en une quantité valant de 0,1 à 15% en poids, par rapport au poids des composants non volatils du mélange, et est un peroxyde organique conforme à l'une des formules générales I et II suivantes :

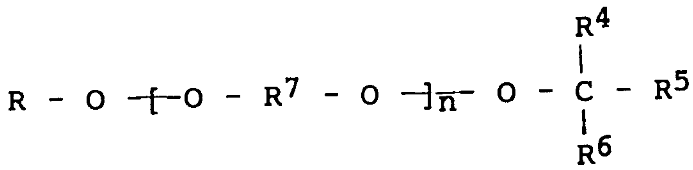 (I)

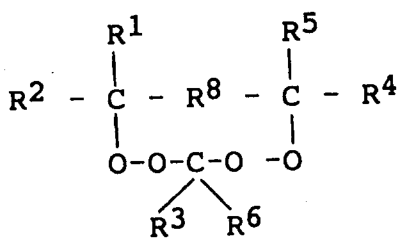 (II)

dans lesquelles
R est un groupe acyle ou le groupe

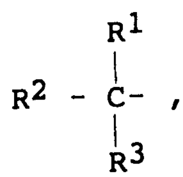

$R^1$ à $R^6$ représentent des radicaux alkyle, alcényle, cycloalkyle, arylalkyle ou aryle, identiques ou différents, deux radicaux alkyle fixés sur un atome de carbone pouvant former un groupe cycloalkylène,
$R^7$ est un groupe alkylène, cycloalkylène, alcénylène, alcinylène, arylalkylène ou arylène,
$R^8$ est une liaison simple ou un groupe alkylène,
et
n est égal à 0 ou 1.

2. Mélange photosensible selon la revendication 1, caractérisé en ce que les atomes de carbone de $R^7$ qui sont liés aux groupes peroxyde sont des atomes de carbone aliphatique tertiaire.

3. Mélange photosensible selon la revendication 1, caractérisé en ce que les radicaux $R^1$, $R^2$, $R^4$ et $R^5$ sont des groupes alkyle ayant de 1 à 4 atomes de carbone.

4. Mélange photosensible selon la revendication 1, caractérisé en ce que le liant polymère est insoluble dans l'eau et soluble ou capable de gonfler dans des solutions aqueuses alcalines.

5. Mélange photosensible selon la revendication 4, caractérisé en ce que le liant polymère est un produit de réaction d'un anhydride intramoléculaire dérivé d'un acide organique polycarboxylique avec un polymère synthétique contenant des groupes hydroxyle mais ne contenant pas d'autres groupes fonctionnels capables de réagir avec des anhydrides d'acides.

6. Mélange photosensible selon la revendication 5, caractérisé en ce que le polymère synthétique est un poly(acétal de vinyle) ou poly(acétate de vinyle) ayant des groupes hydroxyle libres.

7. Mélange photosensible selon la revendication 5, caractérisé en ce que l'acide organique polycarboxylique est un acide dicarboxylique ou un acide tricarboxylique.

8. Mélange photosensible selon la revendication 1, caractérisé en ce que le produit de polycondensation de sel de diazonium est constitué d'unités $A-N_2X$ et B récurrentes, liées les unes aux autres par des

liaisons pontantes, de préférence, par des groupes méthylène, dérivées de composés carbonyle capables de se condenser, A étant le radical d'un composé diazonium aromatique capable de se condenser avec le formaldéhyde et B étant le radical d'un composé, dépourvu de groupes diazonium, capable de se condenser avec le formaldéhyde, en particulier, d'une amine aromatique, d'un phénol, d'un éther phénolique, d'un thioéther aromatique, d'un hydrocarbure aromatique, d'un composé aromatique hétérocyclique ou d'un amide d'acide organique.

**9.** Mélange photosensible selon la revendication 1, caractérisé en ce qu'il contient de 5 à 80% en poids de produit de polycondensation de sel de diazonium et de 20 à 95% en poids de liant polymère.

**10.** Matériau d'enregistrement photosensible ayant une couche support et une couche photosensible, caractérisé en ce que la couche photosensible est constituée d'un mélange selon la revendication 1.

**11.** Procédé pour préparer des matrices d'impression planographique, lors duquel on éclaire et on développe, conformément au format d'image, un matériau d'enregistrement photosensible ayant une couche photosensible à base de produits de polycondensation de sels de diazonium et on chauffe ensuite l'ensemble à une température élevée, caractérisé en ce que l'on utilise un matériau d'enregistrement photosensible selon la revendication 10 et on chauffe le matériau exposé à une température située au-dessus de 120 ° C pendant une courte durée.

**12.** Procédé selon la revendication 11, caractérisé en ce que le matériau est chauffé à une température valant de 140 à 230 ° C.

**13.** Procédé selon la revendication 11, caractérisé en ce que le matériau est chauffé pendant une durée valant de 0,3 à 10 minutes.